# EUROPEAN PATENT APPLICATION

(11) **EP 4 426 078 A1**
(43) Date of publication of application: **04.09.2024**
(21) Application number: 23159285.8
(22) Date of filing: 01.03.2023
(51) Int. Cl.: H05K 5/03, H05K 5/06, H05K 5/00, H05K 5/02, H01R 13/52

(54) **ELECTRONIC CONTROL UNIT COVER, ELECTRONIC CONTROL UNIT (ECU) AND METHOD FOR ASSEMBLING AN ECU**

(71) Applicant: KNORR-BREMSE Systeme für Nutzfahrzeuge GmbH, 80809 München (DE)
(72) Inventor: KUMBHAR, Sagar, 411018 Pune (IN); DOKE, Dhirajkumar, 411057 Pune (IN); SAWANT, Aniket, 411041 Pune (IN)

(57) **Abstract**

An electronic control unit (ECU) cover (10) adapted for assembly with a housing (50) of an ECU (1) within a compartment (2) of a vehicle which is exposed to environmental impacts comprises a first cover section (11) which is configured to accommodate at least one printed circuit board (PCB) (41, 42) and a second cover section (12) integrated with the first cover section (11) and comprising an integrated connector section (13) in which a plurality of connector terminals (21, 22, 2n) is mounted. The first and second cover sections (11, 12) are forming at least in part a top region (31) of the cover (10) which is adapted to cover an inner space (60) of the housing (50) on an upper side thereof when assembled within the compartment (2) of the vehicle. The connector terminals (21, 22) of the plurality of connector terminals (21, 22, 2n) each comprise a respective first connector terminal section (21-1, 22-1) having a first longitudinal extension (ey) extending away from the top region (31) of the ECU cover (10) in a closing, particularly downward, direction (y) towards the inner space (60) of the housing (50) for contact connection to a respective counter terminal in the inner space (60) of the housing (50), and a respective second connector terminal section (21-2, 22-2) having a second longitudinal extension (ex) extending transverse to the first longitudinal extension (ey) of the respective first connector terminal section (21-1, 22-1) towards the at least one PCB (41, 42) for contact connection to the at least one PCB (41, 42). The invention further comprises a corresponding electronic control unit (ECU) and method for assembling an ECU.

## Description

The present disclosure is directed to an electronic control unit cover, an electronic control unit (ECU), and a method for assembling an ECU.

An ECU (abbreviation for electronic control unit) is typically known in the art as a module assembled in a vehicle which comprises electronic circuitry or components contained in a housing and is configured to control a function of the vehicle or a system within the vehicle to which the module is connected via one or more electrical connectors.

A vehicle known in the art (e.g. a wheeled vehicle, such as an automobile, a truck, a trailer, or rail vehicle) often includes one or more ECUs, which may include for example an engine control unit for controlling the engine of the vehicle or brake control unit for controlling the braking of the vehicle. The circuitry of an ECU is contained inside the ECU housing, which may be made from metal or plastics material and is configured to be assembled within a compartment of the vehicle. For example, it may be mounted in the engine compartment or elsewhere on the vehicle, either internally or externally on the chassis or bodywork of the vehicle. A compartment such as an engine compartment or other compartment of the vehicle such as a wheel house may be exposed to varying environmental impacts, such as harsh environmental influences like humidity, water, and/or high temperatures. Therefore, there are typically increased protection requirements for an ECU cover and housing regarding protecting an inner space of the ECU housing against such influences.

In addition, ECUs, such as engine or brake control units, often require numerous incoming and outgoing signal pathways and so are typically connected to a vehicle wiring harness using one or a plurality of electrical connectors, each connector having one or more connector terminals mounted in a connector body. In addition to protecting an inner space of an ECU housing, there are also typically increased demands for protecting such electrical connectors against environmental influences as described above, which may be difficult since the assembly may be arranged in a restricted space available in smaller vehicles or compartments, where access for assembling and sealing purposes is difficult.

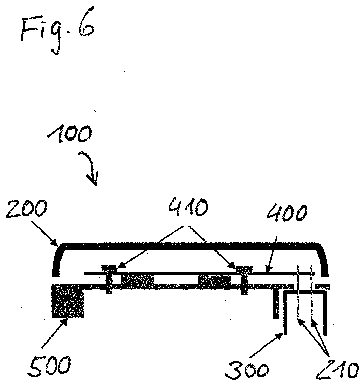

Fig. 6 shows an exemplary current design of an ECU 100 comprising a cover 200 and housing 500 in which electrical components (not shown) are arranged in an inner space of the housing 500. A printed circuit board (PCB) 400 is arranged in a space inside the cover 200 above the housing 500 and fastened, e.g., by mounting screws 410. The PCB 400 may have one or more integrated circuits thereon for electrical connection to electrical components within the ECU housing 500. For example, the PCB 400 is mounted to the upper side of the housing 500 by means of the mounting screws 410.

The ECU 100 is also provided with a plurality of incoming and outgoing signal pathways and, to this end, connected to a wiring harness (not shown) using a separate electrical connector 300, as shown in an example, comprising connector terminals 210 mounted in a separate connector body. The connector terminals 210 are, on the one hand, connected to such wiring harness on the downside and, on the other hand, connected to the PCB 400 for connecting the wiring harness to any electrical components inside the ECU housing 500 via the PCB 400. A disadvantage of such arrangement is the relatively high handling effort when assembling the separate electrical connector 300 for contact connection with the PCB 400, especially in restricted spaces such as an engine compartment of a vehicle. In addition, the electrical connector 300, the ECU housing 500 and ECU cover 200 should be closely mounted with one another for protecting the inner electrical components of the ECU against environmental impacts, as described above, which additionally leads to relatively high assembling effort and manufacturing costs.

It would therefore be beneficial to provide an ECU cover and an ECU which are adapted for assembly within a compartment of a vehicle which is exposed to environmental impacts and which are structured so that assembling effort and manufacturing costs may be decreased.

The invention relates to an ECU cover, an ECU, and to a method for assembling an ECU according to the appended claims. Embodiments are disclosed in the dependent claims.

According to an aspect, there is provided an ECU cover adapted for assembly with a housing of an ECU within a compartment of a vehicle which is exposed to environmental impacts, the ECU cover comprising a first cover section which is configured to accommodate at least one PCB having at least one integrated circuit there-on for electrical connection to the ECU, a second cover section integrated with the first cover section, the second cover section comprising an integrated connector section in which a plurality of connector terminals is mounted. The first and second cover sections are forming at least in part a top region of the cover which is adapted to cover an inner space of the housing on an upper side thereof when assembled within the compartment of the vehicle. The connector terminals of the plurality of connector terminals each comprise a respective first connector terminal section having a first longitudinal extension extending away from the top region of the ECU cover in a closing direction of the ECU cover, particularly downward direction, towards the inner space of the housing for contact connection to a respective counter terminal in the inner space of the housing, and a respective second connector terminal section having a second longitudinal extension extending transverse to the first longitudinal extension of the respective first connector terminal section towards the at least one PCB for contact connection to the at least one PCB.

This enables a compact arrangement and structure of the ECU and a simple assembly and easy handling without needing to handle with bulky wiring harnesses for contacting a PCB arranged on top of the ECU housing and connecting the connector terminals to the PCB. Therefore, the invention is advantageous especially for assembling an ECU which is to be mounted in small compartments or spaces having limited access capabilities. Since the connector and the one or more PCBs are integrated and contained in the ECU cover, the ECU cover can be assembled before assembling of the whole ECU and delivered to the assembly site by the respective supplier. There is thus no need to have a separate provision of a connector strip on the PCB for contact connecting the connector, as for example with the conventional design of Fig. 6. The ECU cover design of the invention has the further advantage that multiple PCBs can be provided and connected to the connector terminals mounted in the ECU cover to distribute features or functions of the ECU on the multiple PCBs.

The invention further enables a direct connection of the one or more PCBs and the connector terminals The connector terminals, by means of the unique terminal design with the first and second connector terminal sections oriented in two different directions (bended design), enable a compact arrangement and structure of the ECU and a simple assembly and easy handling, as described herein.

According to an embodiment, the first longitudinal extension of the respective first connector terminal section is oriented substantially perpendicular to a plane of the top region of the cover.

According to an embodiment, the second longitudinal extension of the respective second connector terminal section is oriented substantially parallel to a plane of the top region of the cover.

According to an embodiment, the at least one PCB is mounted to the top region of the cover.

According to an embodiment, the first cover section is configured to accommodate at least two PCBs in a stack configuration. A first number of the plurality of connector terminals each comprise a respective second connector terminal section for contact connection to a first one of the at least two PCBs, and a second number of the plurality of connector terminals each comprise a respective second connector terminal section for contact connection to a second one of the at least two PCBs.

According to an embodiment, the at least two PCBs are mounted in the stack configuration by means of one or more mounting screws having a respective standoff device arranged between the PCBs.

According to an embodiment, at least the first cover section comprises a sealing element for sealing at least the first cover section against an outer rim of the housing. Preferably, the sealing element is a 2K sealing element. This provides the advantage that a single sealing element can be used for better IP protection.

According to another aspect, there is provided an ECU adapted for assembly within a compartment of a vehicle which is exposed to environmental impacts, comprising a housing for accommodating at least one electronic component of the ECU in an inner space of the housing and an ECU cover according to the invention as described herein, wherein at least the first cover section is arranged to cover the inner space of the housing. The respective first connector terminal sections of the connector terminals are contact connected to a respective counter terminal in the inner space of the housing, and the respective second connector terminal sections of the connector terminals are contact connected to the at least one PCB.

According to an embodiment, the ECU is part of an anti-lock braking system (ABS).

According to another embodiment, the ECU is part of an electronic park brake (EPB) system.

According to a further embodiment, the ECU is part of an electronic levelling control (ELC) system.

According to an embodiment, the vehicle in which the ECU cover and ECU, respectively, is assembled is a wheeled vehicle, such as an automobile, a truck, a trailer, or rail vehicle.

According to another aspect, there is provided a method for assembling an ECU according to the invention as described herein, comprising the following steps:
- providing the housing with at least one electronic component of the ECU in the inner space of the housing,
- providing the ECU cover in which the respective second connector terminal sections of the connector terminals are contact connected to the at least one PCB, and
- arranging the ECU cover in a movement following the closing direction of the ECU cover, particularly downward direction, towards the inner space of the housing such that at least the first cover section covers the inner space of the housing and the respective first connector terminal sections of the connector terminals are contact connected to a respective counter terminal in the inner space of the housing.

Embodiments of the invention will now be described in more detail with reference to the following Figures, in which:
- Fig. 1: shows a cross-sectional view of an ECU cover according to an embodiment of the invention,
- Fig. 2: shows a top view of an ECU cover according to an embodiment of the invention,
- Fig. 3: shows the ECU cover of Fig. 2 from a downward direction according to an embodiment of the invention,
- Fig. 4: shows a perspective view of the ECU cover of Fig. 2 and 3 according to an embodiment of the invention,
- Fig. 5: shows a cross-sectional view of an ECU cover arranged on a housing of an ECU according to a further embodiment of the invention,
- Fig. 6: shows a cross-sectional view of a conventional ECU cover arranged on a housing of an ECU.

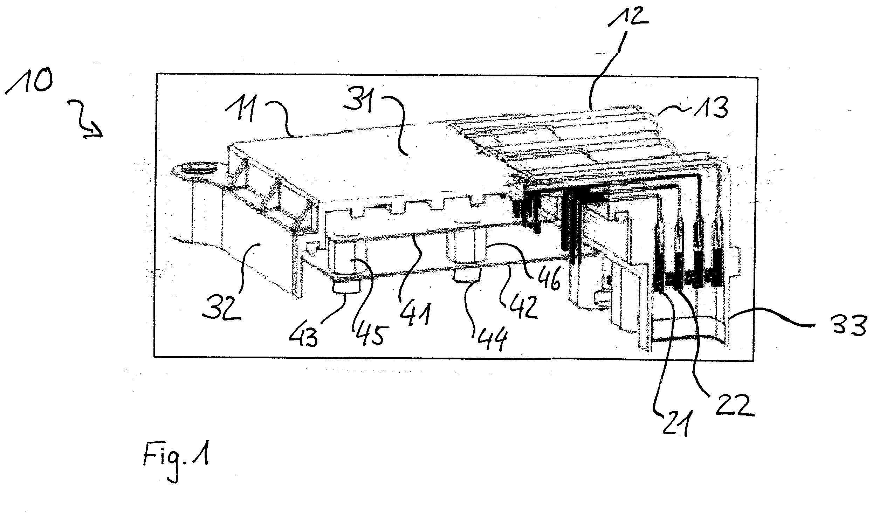

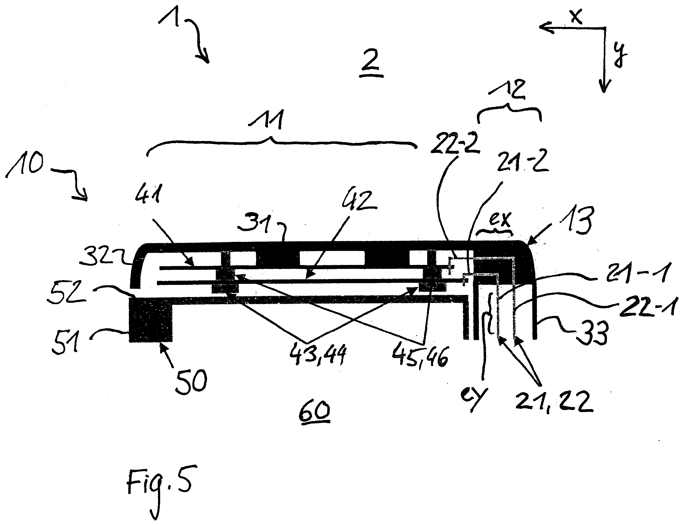

Embodiments of the invention will now be described with reference to **Figures 1 to 5****.** **Fig. 1** **and** **5** respectively show an ECU cover according to an embodiment of the invention in a respective cross-sectional view, wherein **Fig. 5** shows an ECU cover arranged on a housing of an ECU in greater detail. In **Figs. 1 to 5** same or corresponding elements are designated with same reference numerals.

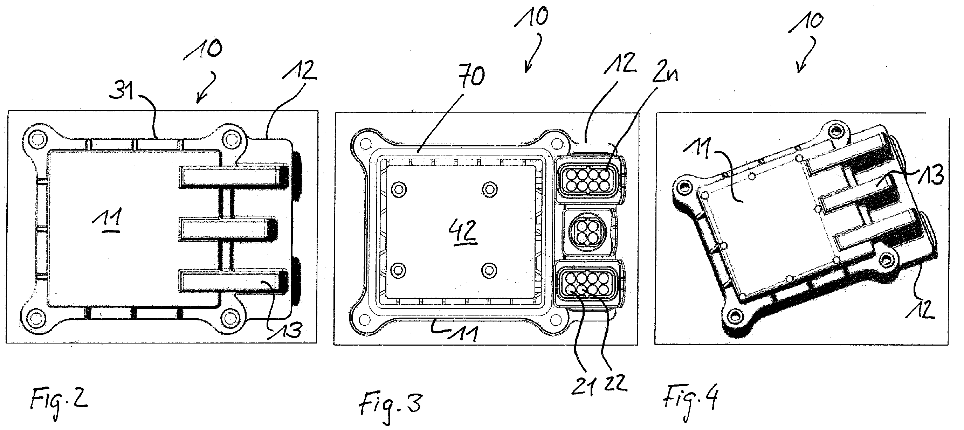

**Fig. 2** shows a top view of the ECU cover according to **Fig. 1** according to an embody-ment, and **Figs. 3 and 4** show the ECU cover of **Fig. 2** from a downward direction and in a perspective view, respectively, according to exemplary embodiments.

Basically, as best shown in **Fig. 5****,** an ECU 1 comprises a housing 50 in which at least one electronic component (not explicitly shown) of the ECU 1 is accommodated in an inner space 60 of the housing 50. For example, the ECU and the at least one electronic component contained therein may be configured as an engine control unit for controlling the engine of the vehicle or brake control unit for controlling the braking of the vehicle. For example, the housing 50 is made from a material as commonly known in the art, such as metal or plastics material. In addition to the housing 50, the ECU 1 further comprises an ECU cover 10 adapted for assembly with the housing 50 such that the inner space 60 with the one or more electronic components is covered by the ECU cover 10 against impacts or influences from the environment. The ECU 1 is assembled within a compartment 2 of a vehicle (not explicitly shown). For example, the ECU 1 is mounted in an engine compartment or wheel compartment of the vehicle, or in any other open or (partially) closed compartment on the vehicle, e.g. internally or externally on the chassis or bodywork of the vehicle. In such locations, the ECU 1 may nevertheless be exposed to varying environmental impacts, such as environmental influences like humidity, fluids (like water or oil) and/or heat (which are typically different from influences in a closed passenger compartment of the vehicle). Therefore, there is an increased protection requirement for the ECU 1, the ECU cover 10 and ECU housing 50 against environmental impacts or influences, particularly regarding protecting the inner space 60 with the one or more electronic components against such impacts or influences.

As best shown in **Fig. 1** **and** **5****,** the ECU cover 10 comprises a first cover section 11 and a second cover section 12. At least the first cover section 11 is structured to cover the inner space 60 of the housing 50. As shown, e.g., in **Fig. 3****,** at least the first cover section 11 comprises a sealing element 70 to be placed on an outer rim 52 of the housing 50 in the assembled ECU 1 (cf. **Fig. 5**) for sealing at least the first cover section 11 against the outer rim 52 of the housing 50. A sealing (like sealing element 70) may also be placed between the second cover section 12 and housing 50. According to a preferred embodiment, the sealing element 70 is a 2K sealing element. A 2K sealing element is a sealing element manufactured by a so-called 2K manufacturing method, in which, for example, an EPDM sealing material is jointly manufactured with a PP support material.

The ECU cover 10, particularly the first cover section 11, also accommodates one or more printed circuit boards (PCBs), such as PCB 41, and in the present embodiment two PCBs 41, 42. The one or more PCBs comprised in the inner space of the ECU cover 10 each have at least one integrated circuit thereon for electrical connection to the ECU 1. For example, in the assembled state of the ECU 1, the at least one integrated circuit on the one or more PCBs is connected to the one or more electronic components of the ECU 1 comprised in the inner space 60 of the housing 50.

The second cover section 12 of the ECU cover 10 is integrated with the first cover section 11, i.e. they are not separate elements. Particularly, the first and second cover sections 11, 12 are forming at least in part a top region 31 of the cover 10 which is adapted to cover the inner space 60 of the housing 50 on an upper side thereof when assembled within the compartment 2 of the vehicle. The one or more PCBs 41, 42 are mounted to the top region 31 of the cover 10, i.e. they are not mounted to the housing 50.

The second cover section 12 comprises an integrated connector section 13 (i.e. they are not separate elements) in which a plurality of connector terminals is mounted. Basically, the integrated connector section 13 may comprise any suitable number N of connector terminals, wherein an exemplary arrangement of N connector terminals is illustrated in **Figs. 1****,** **3****, and** **5** with connector terminals 21 to 2n. For example, the connector section 13 of the second cover section 12 comprises one or more mounting parts or mounting elements in which the connector terminals 21 to 2n are mounted. The connector terminals may be respectively used for transmitting a variety of signals, such as sensor signals to be transmitted to the ECU 1, engine status and control signals or activation/deactivation signals to be transmitted to and from the ECU 1, and/or may be used as power supply terminals.

In **Fig. 5****,** the ECU 1 is shown in an assembled state having an exemplary orientation as mounted in the vehicle compartment 2, or after assembling and before mounting to the vehicle compartment 2. The two-dimensional coordinate system x, y is related to a state in which the housing 50 is placed or mounted on a horizontal plane which is parallel to the x direction. In such state, the housing 50, particularly its bottom (not explicitly shown), is oriented horizontally, i.e. in the x direction. In such state, the ECU cover 10 is oriented such that the top region 31 of the cover 10 is oriented substantially horizontally, i.e. in the x direction, and the side wall 32 of the cover 10 and side wall 51 of the housing 50 are oriented substantially vertically in a downward direction, i.e. in the y direction which is perpendicular to the x direction. Oriented substantially horizontally and vertically/in downward direction shall also encompass orientations which are not strictly horizontal or vertical/downward, but are within usual tolerances.

When it is referred herein to orientations of components in space, such as upper, lower, downward or upward, this shall be understood as being in relation to such horizontal orientation of the (bottom of the) housing of the ECU, particularly in relation to the x,y coordinate system, as shown, with the x direction oriented horizontally.

As best shown in **Fig. 5****,** the ECU cover 10 comprises in the connector section 13 an integrated connector housing 33 in which connector terminals 21 and 22 are arranged. Generally, the integrated connector housing 33 may comprise any number N of connector terminals. In the present example, two connector terminals 21 and 22 are visible in the cross-sectional view of **Fig. 5****.** The connector terminals 21, 22 mounted in the connector section 13 each comprise a respective first connector terminal section 21-1, 22-1 and a respective second connector terminal section 21-2, 22-2, particularly arranged on opposite sides of the connector terminals 21, 22. For example, the first and second connector terminal sections 21-1, 22-1, 21-2, 22-2 are formed as respective contacts, such as a male and/or female contact. In the present example, the first and second connector terminal sections 21-1, 22-1, 21-2, 22-2 are formed as respective pin contacts. The respective first connector terminal sections 21-1, 22-1 each have a first longitudinal extension ey extending away from the top region 31 of the ECU cover 10 in in a closing direction (here: the y direction) of the ECU cover 10, in the present embodiment a downward direction. As shown in **Fig. 5****,** the closing direction of closing the ECU cover 10 towards the inner space 60 of the housing 50 (here: the downward direction) is the y direction of the two-dimensional coordinate system x, y illustrated in **Fig. 5****.** That is, the first connector terminal sections 21-1, 22-1 each have a first longitudinal extension ey extending away from the top region 31 of the ECU cover 10 in the closing (downward) direction y towards the inner space 60 of the housing 50 for contact connection to a respective counter terminal (not explicitly shown) in the inner space 60 of the housing 50. That is, the connector terminals 21, 22 (here the first connector terminal sections 21-1, 22-1) are oriented in the same direction as the cover closing direction of the ECU cover 10. This provides the advantage that with the placement of the ECU cover 10 on the housing 50 in the closing, e.g. downward, movement, the first connector terminal sections 21-1, 22-1 are automatically getting contact connected to a respective counter terminal in the inner space 60 of the housing 50 with the same movement, and no separate handling of a wiring harness is necessary in this regard.

On the other hand, the respective second connector terminal sections 21-2, 22-2 have a second longitudinal extension ex which is extending transverse to the first longitudinal extension ey of the respective first connector terminal sections 21-1, 22-1, and which is extending towards the one or more PCBs 41, 42 for contact connection to the respective PCB 41, 42.

As best shown in **Fig. 5****,** the first longitudinal extension ey of the respective first connector terminal section 21-1, 22-1 is oriented substantially perpendicular to the plane of the top region 31 of the cover 10, whereas the second longitudinal extension ex of the respective second connector terminal section 21-2, 22-2 is oriented substantially parallel to the plane of the top region 31 of the cover 10. Oriented substantially perpendicular or parallel shall also encompass orientations which are not strictly perpendicular or parallel, but are within usual tolerances.

As further shown in **Fig. 5****,** the first cover section 11 accommodates the two or more PCBs 41, 42 in a stack configuration, i.e. one above the other spaced apart by a respective distance. The PCBs 41, 42 are mounted to the first cover section 11 in the stack configuration by means of one or more mounting screws 43, 44 having a respective standoff device 45, 46 (such as screw nuts) arranged between the PCBs 41, 42. Thus, in this embodiment the second connector terminal section 21-2 of the connector terminal 21 is contact connected to PCB 42, and the second connector terminal section 22-2 of the connector terminal 22 is contact connected to PCB 41.

According to an embodiment, the ECU 1 may be assembled as follows: In a first step, the housing 50 is provided with at least one electronic component of the ECU 1 accommodated in the inner space 60 of the housing 50. In addition, the ECU cover 10 is provided, wherein the respective second connector terminal sections 21-2, 22-2 of the connector terminals 21, 22 are contact connected to the PCBs 41, 42.

For assembling the ECU 1, the ECU cover 10 (including the PCBs 41, 42 and contact terminals 21, 22) is arranged above the inner space 60 of the housing 50 and moved downward in closing direction y towards the inner space 60 of the housing 50 such that the first cover section 11 covers the inner space 60 of the housing 50 and the first connector terminal sections 21-1, 22-1 of the connector terminals 21, 22 are contact connected to a respective counter terminal in the inner space 60 of the housing 50.

This enables a compact arrangement and structure of the ECU 1 and a simple assembly and easy handling without needing to handle with bulky wiring harnesses for contacting a PCB arranged on top of the ECU housing and connecting the connector terminals. Therefore, the invention is advantageous especially for assembling an ECU which is to be mounted in small compartments having limited access capabilities.

Advantageously, the ECU according to the invention may be used as an ECU of an anti-lock braking system (ABS), an electronic park brake (EPB) system, or an electronic levelling control (ELC) system.

### REFERENCE SIGNS LIST

- 1: ECU
- 2: compartment
- 10: ECU cover
- 11: first cover section
- 12: second cover section
- 13: connector section
- 21, 22, 2n: connector terminals
- 21-1, 22-1: first connector terminal section
- 21-2, 22-2: second connector terminal section
- 31: top region
- 32: side wall
- 33: integrated connector housing
- 41,42: PCB
- 43, 44: mounting screws
- 45, 46: standoff device
- 50: housing
- 51: side wall
- 52: outer rim
- 60: inner space
- 70: sealing
- 100: ECU
- 200: cover
- 210: connector terminals
- 300: electrical connector
- 400: PCB
- 410: mounting screws
- 500: housing
- ey: first longitudinal extension
- ex: second longitudinal extension

## Claims

1. An electronic control unit, ECU, cover (10) adapted for assembly with a housing (50) of an ECU (1) within a compartment (2) of a vehicle which is exposed to environmental impacts, the ECU cover (10) comprising:
- a first cover section (11) which is configured to accommodate at least one printed circuit board, PCB, (41, 42) having at least one integrated circuit thereon for electrical connection to the ECU (1),
- a second cover section (12) integrated with the first cover section (11), the second cover section (12) comprising an integrated connector section (13) in which a plurality of connector terminals (21, 22, 2n) is mounted,
- wherein the first and second cover sections (11, 12) are forming at least in part a top region (31) of the cover (10) which is adapted to cover an inner space (60) of the housing (50) on an upper side thereof when assembled within the compartment (2) of the vehicle,
- wherein the connector terminals (21, 22) of the plurality of connector terminals (21, 22, 2n) each comprise a respective first connector terminal section (21-1, 22-1) having a first longitudinal extension (ey) extending away from the top region (31) of the ECU cover (10) in a closing direction (y) of the ECU cover (10), particularly downward direction (y), towards the inner space (60) of the housing (50) for contact connection to a respective counter terminal in the inner space (60) of the housing (50), and a respective second connector terminal section (21-2, 22-2) having a second longitudinal extension (ex) extending transverse to the first longitudinal extension (ey) of the respective first connector terminal section (21-1, 22-1) towards the at least one PCB (41, 42) for contact connection to the at least one PCB (41, 42).

2. The ECU cover according to claim 1, wherein the first longitudinal extension (ey) of the respective first connector terminal section (21-1, 22-1) is oriented substantially perpendicular to a plane of the top region (31) of the cover.

3. The ECU cover according to claim 1 or 2, wherein the second longitudinal extension (ex) of the respective second connector terminal section (21-2, 22-2) is oriented substantially parallel to a plane of the top region (31) of the cover.

4. The ECU cover according to one of claims 1 to 3, wherein the at least one PCB (41, 42) is mounted to the top region (31) of the cover.

5. The ECU cover according to one of claims 1 to 4, wherein the first cover section (11) is configured to accommodate at least two PCBs (41, 42) in a stack configuration, and a first number of the plurality of connector terminals (21) each comprise a respective second connector terminal section (21-2) for contact connection to a first one of the at least two PCBs (41), and a second number of the plurality of connector terminals (22) each comprise a respective second connector terminal section (22-2) for contact connection to a second one of the at least two PCBs (42).

6. The ECU cover according to claim 5, wherein the at least two PCBs (41, 42) are mounted in the stack configuration by means of one or more mounting screws (43, 44) having a respective standoff device (45, 46) arranged between the PCBs (41, 42).

7. The ECU cover according to one of claims 1 to 6, wherein at least the first cover section (11) comprises a sealing element (70) for sealing at least the first cover section (11) against an outer rim (52) of the housing (50).

8. The ECU cover according to claim 7, wherein the sealing element (70) is a 2K sealing element.

9. An electronic control unit, ECU, (1) adapted for assembly within a compartment (2) of a vehicle which is exposed to environmental impacts, comprising:
- a housing (50) for accommodating at least one electronic component of the ECU (1) in an inner space (60) of the housing (50),
- an ECU cover (10) according to one of the preceding claims, wherein at least the first cover section (11) is arranged to cover the inner space (60) of the housing (50),
- wherein the respective first connector terminal sections (21-1, 22-1) of the connector terminals (21, 22) are contact connected to a respective counter terminal in the inner space (60) of the housing (50), and the respective second connector terminal sections (21-2, 22-2) of the connector terminals (21, 22) are contact connected to the at least one PCB (41, 42).

10. The ECU according to claim 9, wherein the ECU (1) is part of an anti-lock braking system, ABS.

11. The ECU according to claim 9, wherein the ECU (1) is part of an electronic park brake, EPB, system.

12. The ECU according to claim 9, wherein the ECU (1) is part of an electronic levelling control, ELC, system.

13. A method for assembling an ECU (1) according to one of claims 9-12, comprising the following steps:
- providing the housing (50) with at least one electronic component of the ECU in the inner space (60) of the housing (50),
- providing the ECU cover (10) in which the respective second connector terminal sections (21-2, 22-2) of the connector terminals (21, 22) are contact connected to the at least one PCB (41, 42), and
- arranging the ECU cover (10) in a movement following the closing direction (y) of the ECU cover (10), particularly downward direction (y), towards the inner space (60) of the housing (50) such that at least the first cover section (11) covers the inner space (60) of the housing (50) and the respective first connector terminal sections (21-1, 22-1) of the connector terminals (21, 22) are contact connected to a respective counter terminal in the inner space (60)
